# EUROPEAN PATENT APPLICATION

(11) **EP 4 687 287 A1**
(43) Date of publication of application: **04.02.2026**
(21) Application number: 25192430.4
(22) Date of filing: 29.07.2025
(51) Int. Cl.: H03F 1/30, H03F 1/32, H03F 3/189, H03F 3/24, H04B 1/04

(54) **DIGITAL PREDISTORTION SYSTEM ENHANCEMENT UNDER DYNAMIC OPERATION**

(30) Priority: 31.07.2024 US 202463677879 P
(71) Applicant: Analog Devices International Unlimited Company, Limerick (IE)
(72) Inventor: BEN REJEB, Marwen, Co. Limerick (IE); RASLAN, Ahmed M. R. A., Co. Limerick (IE); OUTALEB, Noureddine, Co. Limerick (IE)
(74) Representative: Yang, Shu

(57) **Abstract**

A device may include a first model implemented using a first processing circuit configured to implement a transformation function to generate an initial predistortion signal based on an input signal corresponding to an output of a power amplifier. The device may include a second model implemented using a second processing circuit configured to implement a modification function to modify the initial predistortion signal. A device may include a configurable multiplier configured to weight an output of the second model based at least in part on a weighting value to obtain a weighted output. A device may include a combiner configured to combine the initial predistortion signal that is output by the first model with the weighted output to generate a digital predistortion signal for the power amplifier in communication with the digital predistortion system.

## Description

### INCORPORATION BY REFERENCE

This application claims priority to U.S. Provisional Application No. 63/677,879 filed on July 31, 2024, the disclosure of which is hereby incorporated by reference herein for all purposes. Any and all applications for which a foreign or domestic priority claim is identified in the Application Data Sheet as filed with the present application are hereby incorporated by reference under 37 CFR 1.57.

### TECHNICAL FIELD

The present disclosure generally relates to digital compensation for wireless transceivers. Aspects of this disclosure can be implemented in digital pre-distortion (DPD) circuitry. Such circuitry can apply DPD in a transmit path of a transceiver. With DPD of this disclosure, efficient digital models can be extracted to meet high levels of radio performance.

### BACKGROUND

Transceivers may be used by wireless devices to transmit or receive radio frequency signals. Often the signal to be transmitted does not have high enough power to reach its target, such as from a base station to a cellular device. Power amplifiers are typically used to increase the signal strength of the signal to be transmitted enabling it to be transmitted greater distances.

### SUMMARY

The systems, methods and devices of this disclosure each have several innovative aspects, no single one of which is solely responsible for all of the desirable attributes disclosed herein. Details of one or more implementations of the subject matter described in this specification are set forth in the accompanying drawings and the description below.

In some aspects, the techniques described herein relate to a digital predistortion system configured to distort a power amplifier input signal prior to being input to a power amplifier, the digital predistortion system including: a compensator including: a first model implemented using a first processing circuit block configured to implement a transformation function to generate an initial predistortion signal based on an input signal corresponding to an output of a power amplifier; a second model implemented using a second processing circuit block configured to implement a modification function to modify the initial predistortion signal generated by the first model; a weighting processor configured to generate a weighting value based at least in part on a weighting parameter; a configurable multiplier configured to weight an output of the second model based at least in part on the weighting value generated by the weighting processor to obtain a weighted output; and a combiner configured to combine the initial predistortion signal that is output by the first model with the weighted output to generate a digital predistortion signal for the power amplifier in communication with the digital predistortion system.

In some aspects, the techniques described herein relate to a digital predistortion system, wherein the first model includes a primary model configured to generate the initial predistortion signal and the second model includes a secondary model configured to modify the primary model according to changes in the power amplifier state.

In some aspects, the techniques described herein relate to a digital predistortion system, wherein the weighting parameter includes one or more of a time value, a power output value of the power amplifier, temperature of the power amplifier, or a bandwidth of a transmission signal.

In some aspects, the techniques described herein relate to a digital predistortion system, wherein the weighting value ranges from zero to one. The weighting value is zero when the weighting parameter corresponds to the value at which the primary model is trained, and it is one when the weighting parameter is farthest from this training value.

In some aspects, the techniques described herein relate to a digital predistortion system, wherein the weighting value transitions gradually from zero to one, or vice versa, as the weighting parameter reflects the evolution of the power amplifier from a transient-state to a steady-state condition.

In some aspects, the techniques described herein relate to a digital predistortion system, wherein the weighting parameter corresponds to a characteristic of the input signal, such as power level or bandwidth.

In some aspects, the techniques described herein relate to a digital predistortion system, wherein the first model includes a Volterra based model or a machine learning model that is trained with a characteristic of the input signal set at nominal power.

In some aspects, the techniques described herein relate to a digital predistortion system, wherein the weighting processor generates the weighting value using a real-to-complex operator. Examples of such operators can include, but are not limited to, piecewise functions or neural network activation functions, such as sigmoid function, tanh, or Rectified Linear Unit (ReLU).

In some aspects, the techniques described herein relate to a digital predistortion system, wherein the weighting processor generates the weighting value using a weight generation model that has been trained to track the changes in the state of the power amplifier or the characteristics of the input signal.

In some aspects, the techniques described herein relate to a digital predistortion system, further including a third model implemented using a third processing circuit block configured to implement a second modification function to modify the initial predistortion signal generated by the first model.

In some aspects, the techniques described herein relate to a digital predistortion system, wherein the second modification function modifies the initial predistortion signal generated by the first model based on a second weighting parameter that differs from the weighting parameter.

In some aspects, the techniques described herein relate to a transceiver including: a power amplifier; a digital predistortion system; and a controller configured to generate a control signal to control operation of the digital predistortion system, wherein the digital predistortion system is connected in series with the power amplifier, and wherein the digital predistortion system includes a compensator that includes: a first model implemented using a first processing circuit block configured to implement a transformation function to generate an initial predistortion signal based on an input signal corresponding to an output of the power amplifier; a second model implemented using a second processing circuit block configured to implement a modification function to modify the initial predistortion signal generated by the first model; a weighting processor configured to generate a weighting value based at least in part on the control signal; a configurable multiplier configured to weight an output of the second model based at least in part on the weighting value generated by the weighting processor to obtain a weighted output; and a combiner configured to combine the initial predistortion signal that is output by the first model with the weighted output to generate a digital predistortion signal for the power amplifier in communication with the digital predistortion system.

In some aspects, the techniques described herein relate to a transceiver, wherein the control signal is generated based at least in part on a passage of time over a time period associated with a transmission signal.

In some aspects, the techniques described herein relate to a transceiver, wherein the control signal is generated based at least in part on a power output of the power amplifier.

In some aspects, the techniques described herein relate to a transceiver, wherein the weighting processor generates the weighting value using a weight generation model that has been trained to track the changes in the state of the power amplifier or the characteristics of the input signal.

In some aspects, the techniques described herein relate to a transceiver, wherein the digital predistortion system further includes a third model implemented using a third processing circuit block configured to implement a second modification function to modify the initial predistortion signal generated by the first model.

In some aspects, the techniques described herein relate to a transceiver, wherein the control signal is associated with a weighting parameter corresponding to the input signal, and wherein the second modification function modifies the initial predistortion signal generated by the first model based on a second control signal that is associated with a different weighting parameter than the control signal.

In some aspects, the techniques described herein relate to a wireless device including: an antenna configured to emit a signal received from a power amplifier; and a transceiver including the power amplifier and a digital predistortion system connected in series with the power amplifier, the digital predistortion system including: a primary model implemented using a first processing circuit block configured to implement a transformation function to generate an initial predistortion signal based on an input signal corresponding to an output of the power amplifier; an auxiliary model implemented using a second processing circuit block configured to implement a modification function to modify the initial predistortion signal generated by the primary model; a weighting processor configured to generate a weighting value based at least in part on a control signal; a configurable multiplier configured to weight an output of the auxiliary model based at least in part on the weighting value generated by the weighting processor to obtain a weighted output; and a combiner configured to combine the initial predistortion signal that is output by the primary model with the weighted output to generate a digital predistortion signal for the power amplifier in communication with the digital predistortion system.

In some aspects, the techniques described herein relate to a wireless device, wherein the wireless device is a base station.

In some aspects, the techniques described herein relate to a wireless device, wherein the control signal corresponds to a characteristic of the input signal.

Although certain embodiments and examples are disclosed herein, inventive subject matter extends beyond the examples in the specifically disclosed embodiments to other alternative embodiments and/or uses, and to modifications and equivalents thereof.

### BRIEF DESCRIPTION OF THE DRAWINGS

Aspects and advantages of the embodiments provided herein are described with reference to the following detailed description in conjunction with the accompanying drawings. Throughout the drawings, reference numbers may be re-used to indicate correspondence between referenced elements. The drawings are provided to illustrate example embodiments described herein and are not intended to limit the scope of the disclosure. In addition, various features of different disclosed embodiments can be combined to form additional embodiments, which are part of this disclosure. Further, one or more features or structures can be removed or omitted.
Figure 1A illustrates an example of a digital linearization system in accordance with certain embodiments.
Figure 1B illustrates a graph of charge trapping effect of certain GaN power amplifiers in accordance with certain embodiments.
Figure 1C illustrates a graph of a degradation in linearity due to trapping effect of GaN power amplifier operated in TDD mode in accordance with certain embodiments.
Figure 2 illustrates a portion of a wireless system that includes a transceiver radio that implements digital predistortion in accordance with certain embodiments.
Figure 3 illustrates an example implementation of a digital predistortion system with one auxiliary model in accordance with certain embodiments.
Figure 4 illustrates an example implementation of a digital predistortion system with multiple auxiliary models in accordance with certain embodiments.

### DETAILED DESCRIPTION OF CERTAIN EMBODIMENTS

The headings provided herein, if any, are for convenience only and do not necessarily affect the scope or meaning of the claimed invention. For the purpose of the present disclosure, the terms mobile devices and wireless devices are used interchangeably.

### Introduction

Often new wireless technologies require transmitters to operate more efficiently without compromising the radio frequency performance (e.g., signal integrity and emissions) and implementation area. An area where improved efficiency is particularly desired is in the power amplifier, with a specific focus on maximizing efficiency while maintaining linearity performance within specified limits.

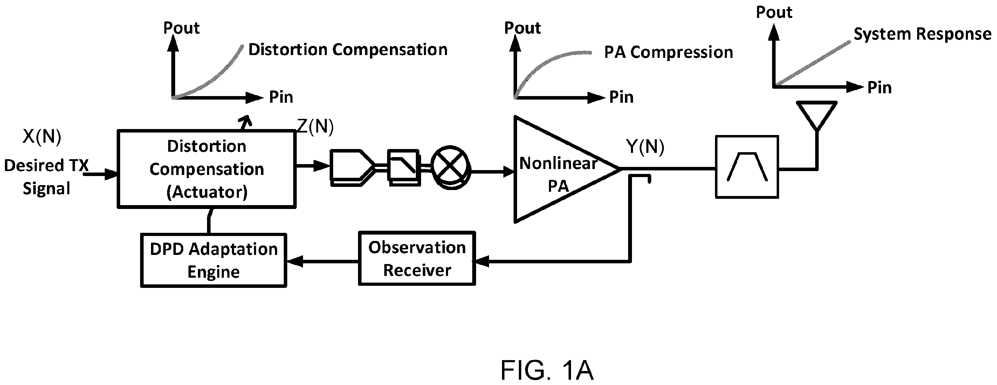

As illustrated in Figure 1A, a nonlinear power amplifier can be configured to generate a linear output by distorting an input to the power amplifier such that the total system response is linear. Digital predistortion can be used to distort the desired transmit signal such that the output of the power amplifier is linear. The nonlinear distortion compensation generated by the distortion compensation circuit combined with the nonlinear output of the power amplifier can result in a total system response that is linear.

Figure 1A illustrates a simplified block diagram illustrating an example digital predistortion system in accordance with certain embodiments. As illustrated, the DPD actuation circuit can receive an input signal x(n). The signal x(n) can be a transmit signal. Predistortion can be applied to the signal x(n) to obtain a power amplifier input signal z(n). The predistortion can be determined based at least in part on a DPD estimation circuit that can implement a model to estimate an amount of predistortion to apply to the signal x(n). The model may base its output or estimation on the input signal x(n), the output of the power amplifier, y(n) as well as the power amplifier input signal z(n). The predistortion estimation circuit can implement an iterative process where it updates the parameters of the DPD model overtime.

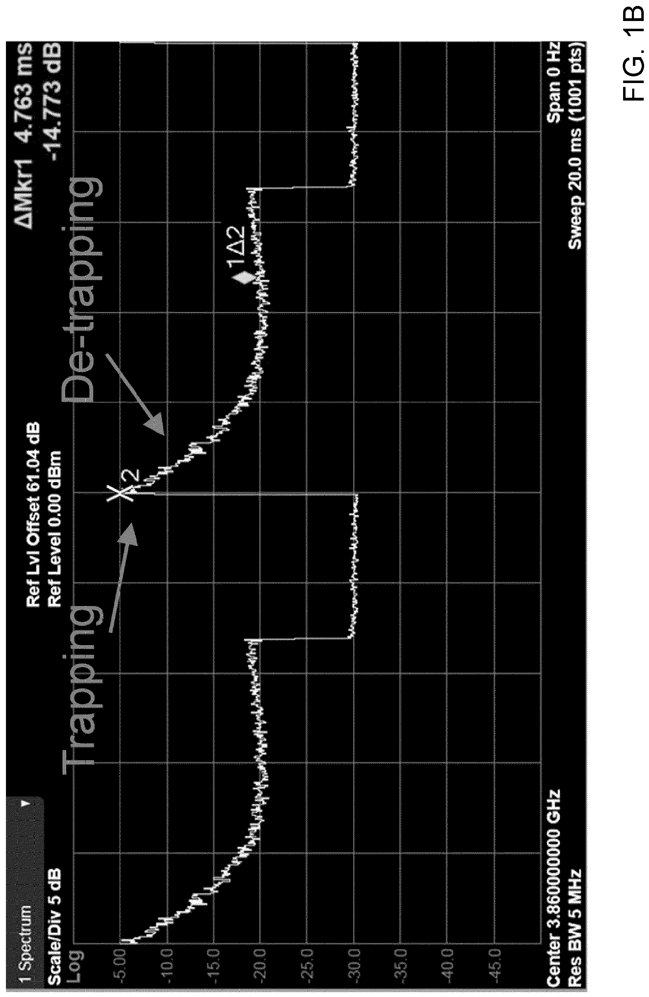

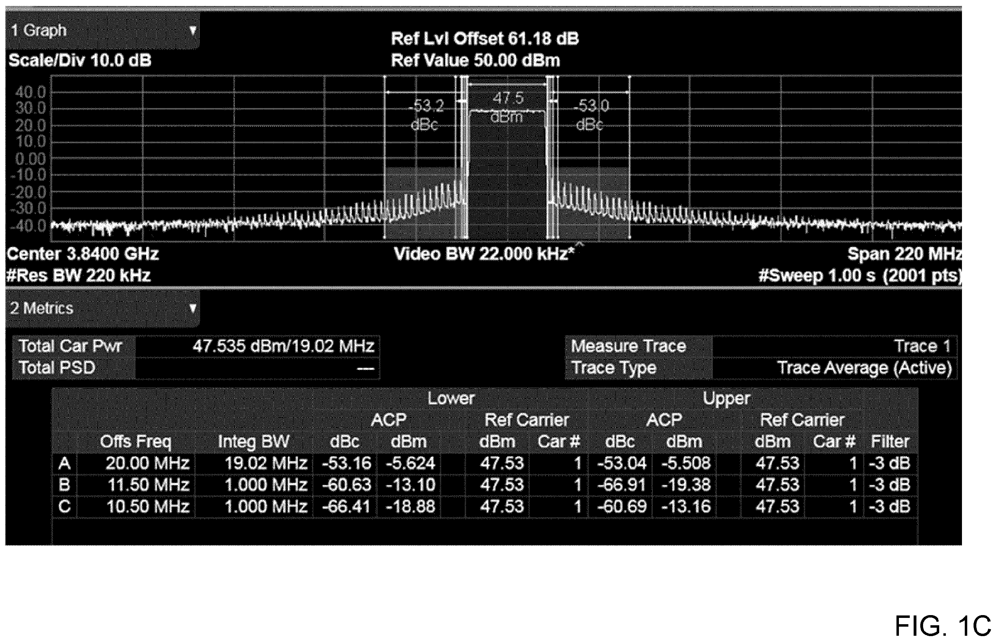

The distortion generated by the digital predistortion system can be based on the output of the power amplifier. A number of factors can impact the accuracy of the digital predistortion (DPD) output by the digital predistortion system. With some newer communication standards, such as 5G and the upcoming 6G, time-division duplexing (TDD) where transceivers alternate between transmission and reception is becoming the dominant standard communication method between transmitter and receiver nodes. In order to increase efficiency of transceivers, the use of Gallium Nitride (GaN) technology is becoming more common for power amplifiers. However, there are some side effects of relying on GaN power amplifiers including, for example, the trapping effect illustrated in Figure 1B especially when a base station does not transmit continuously in TDD mode. When the base station is receiving, the signal drops to zero until next transmission. Hence, when the base station is sending or transmitting, and when a GaN power amplifier is used, a trapping effect may occur where electrons that are trapped in a junction of the device may cause a spike in the signal, which settles over time as de-trapping occurs. The trapped electrons can create memory effects that causes spikes in the signal as illustrated in Figure 1C. The memory effects may be characterized by a slow shift on the characteristics of the power amplifier, which can make use of the power amplifier challenging in situations where the modulated envelope signal has a wide amplitude variation over time, such as in time-division duplexing (TDD).

Increasing the accuracy of the digital predistortion can be achieved through the use of more complex models that may be used to determine the distortion to apply to the nonlinear power amplifier. In some cases, a plurality of different models may be used to account for different use cases. The more models that are applied, the more accurate the digital predistortion can be under different use cases. However, increasing the complexity of the models or the number of models can result in greater circuit area and power consumption.

Deploying a digital Predistortion (DPD) system into the field faces challenges owing to its dynamic characteristics that encompasses aspects like variable bandwidth and power fluctuations. Furthermore, the fast integration of Gallium Nitride (GaN) technology in power amplifiers (PAs), coupled with the increasing reliance on Time Division Duplex (TDD) operations featuring burst transmissions, adds complexity to the DPD adaptation scheme. One approach to this problem involves expanding the utilization of multi-table DPD, each modeling a specific PA state. However, this approach may encounter hardware and software scalability issues particularly when addressing diverse sources of dynamics simultaneously. The proposed innovation introduces two models or more, representing distinct PA states, that are combined using a weighing function to capture the transition between the states for each dynamic source. This approach not only enhances implementation efficiency but also preserves performance, providing a notable gain in overall system.

The present disclosure relates to a dynamic digital predistortion system that can increase the accuracy of the distortion applied to the power amplifier input signal while reducing complexity and size. In certain embodiments, a single primary or main model is used to generate digital predistortion. The system may further include one or more auxiliary or secondary models that can adjust or adapt the output of the primary model to account for the challenges identified above, among others. For example, at the start of the transmission period, digital predistortion can be applied by the primary model. As de-trapping occurs, the output of the primary model can be adjusted over time based on the secondary model. Thus, referring back to Figure 1B, a first model may be used at the onset of a transmit signal when trapping occurs. At this point in time, there may be little or no contribution from the auxiliary model. As de-trapping occurs, a secondary model may be used to adjust the output of the primary model in such a way to compensate for the de-trapping time constant. This model adjustment may occur by combining the outputs of the primary and auxiliary models. Over time, the weight applied to the auxiliary model may be increased to account for the declining impact of the trapping.

A similar process may be used to account for other characteristics or features of the input signal to be applied to the power amplifier to modify the predistortion. For example, under a dynamic drive input signal, the instantaneous gain response of the power amplifier may be varied because of the charge trapping effect. Based on instantaneous gain response of the power amplifier, the weight of the auxiliary model may be varied. As another example, the weight of the auxiliary model may be varied based on bandwidth of the signal.

The auxiliary model is typically smaller and less complex than the primary model. Advantageously, in certain embodiments, using an auxiliary model to adjust the primary model under certain conditions (e.g., over time, different power levels, different bandwidths, etc.), an improved or more accurate predistortion signal can be generated without the drawbacks of having different models in terms of circuit area and power consumption, among others.

he models may be implemented using Volterra-series framework, neural networks or any other type of model that may be used by a DPD system to generate predistortion. Additional examples of models that may be used herein include those described in U.S. Application No. 18/332,323, filed on June 9, 2023, and U.S. Application No. 18/361,697, filed on July 28, 2023, both of which are hereby incorporated by reference in their entirety for all purposes and made a part of the present disclosure.

### Digital Predistortion System

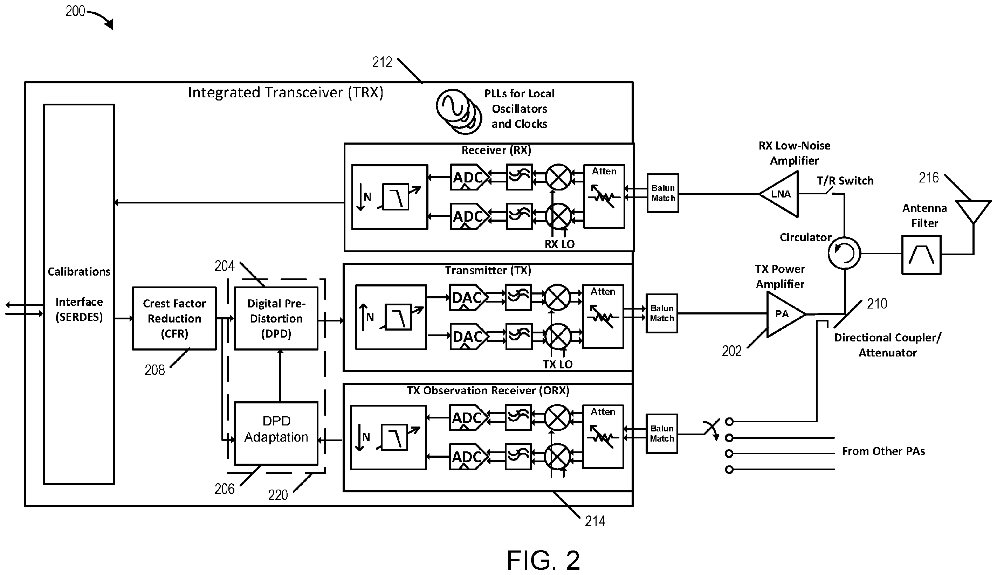

Figure 2 illustrates a portion of a wireless system 200 that includes an integrated transceiver or transceiver radio that implements digital predistortion in accordance with certain embodiments. The wireless system 200 may include, among other circuit elements and systems, a transceiver radio 212 (or integrated transceiver), a power amplifier 202, and a coupler 210. The transceiver radio 212 may include a linearization engine 220 that can linearize the signal to be transmitted by the wireless system 200 by introducing a nonlinearity into the signal that is complementary to the nonlinearity introduced by the power amplifier 202. The linearization engine 220 may include a digital predistortion system 204 and a digital predistortion adaptation system 206 (DPD). The digital predistortion system 204 may introduce nonlinearity into a signal received from a crest factor reduction circuit 208 (CFR) for transmission. The digital predistortion adaptation system 206 may be used to configure models implemented or executed by the digital predistortion system 204. The models may be configured in part based on feedback from the power amplifier 202, which may be provided by a transmitter observation receiver 214 to the digital predistortion adaptation system 206.

In some embodiments, the transceiver radio 212 can include the power amplifier 202. In some embodiments, the transceiver radio 212 outputs a signal for transmission that is provided to the power amplifier 202 to increase the signal strength of the signal for emission or to be emitted by the antenna 216. The coupler 210 can be used to provide a power signal or power measurement from the output of the power amplifier 202 to the transmitter observation receiver 214, which can determine the signal output by the power amplifier 202 based on the measured power received from the coupler 210. The output signal may be provided by the transmitter observation receiver 214 to the digital predistortion adaptation system 206. The digital predistortion adaptation system 206, as described in U.S. Application No. 18/332,323 incorporated by reference above, can use the power amplifier 202 output signal to determine one or more coefficient values for configuring one or more models used by the digital predistortion system 204 to determine a distortion or predistortion signal to apply to the transmit signal prior to being provided to the power amplifier 202. Thus, a feedback mechanism can be used to configure the digital predistortion system 204 enabling an improved compensation system for converting the nonlinear power amplifier 202 output into a linear system response for the wireless system 200 or the transceiver radio 212 of the wireless system 200.

The digital predistortion system 204 can be implemented as a series of compensators or compensation circuits. Each of these compensation circuits can implement different functionality, algorithms, models, or transformation functions, including machine learning based models. In some embodiments, the digital predistortion system 204 can be a multistage system that includes a plurality of compensation circuits connected in series. Advantageously, by using a multistage system, the number of coefficients included in the implemented models can be reduced while maintaining the same or better linearization performance, such as channel leakage ratio.

The digital predistortion system 204 may apply distortion to an input signal corresponding to a signal to be transmitted. The input signal may be received from the crest factor reduction circuit 208. The crest factor reduction circuit 208 may reduce a peak-to-average power ratio (PAPR) of the signal to be transmitted to obtain a reduced PAPR transmit signal. This reduced PAPR transmit signal may be provided as the input to the digital predistortion system 204, which may in turn pre-distort the received signal before it is provided to the power amplifier 202. As illustrated in Figure 2, the output of the digital predistortion system 204 may be provided to other subsequent circuitry (e.g., a transmitter that includes upsamplers, digital to analog converters, mixers, local oscillators, etc.) before it is provided to the power amplifier 202, which may be a separate circuit or may be included as part of the transmitter. Further, the digital predistortion system 204 may apply the pre-distortion based at least in part on feedback received from the power amplifier 202, which is used by the digital predistortion adaptation system 206 to configure the digital predistortion system 204.

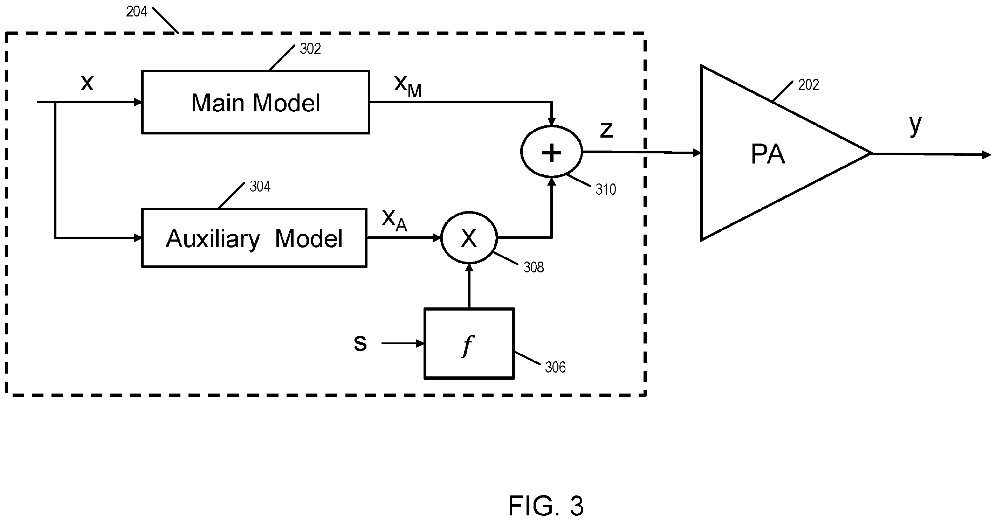

Figure 3 illustrates an example implementation of a digital predistortion system 204 in accordance with certain embodiments. The digital predistortion system 204 may be or may include a compensator that implements a main model, or primary model 302, and an auxiliary model, or secondary model 304. The primary model 302 may be implemented using one or more processing circuit blocks that are configured to implement a transformation function to generate an initial predistortion signal based on an input signal, X, which may correspond to an output of a power amplifier 202.

The primary model 302, may be trained under different conditions of the transmit or input signal, X. In some cases, the primary model 302 implements a machine learning model. This model may be trained based on a characteristic of the input signal associated with a particular value or condition. For example, if the characteristic of the input signal is associated with charge trapping, the model may be trained based on the input signal during the trapping phase (e.g., at the start of the transmission period). As another example, if the characteristic of the input signal is associated with power of the signal, the primary model 302 may be trained assuming a signal of maximum or minimal supported power. The output, X_{M}, of the primary model 302 may comprise a predistorted signal which is a modified input signal that is modified based on a predistortion model.

The secondary model 304 may be implemented using a second processing circuit block configured to implement a modification function to modify the initial predistortion signal generated by the primary model 302. The secondary model 304 may be smaller in size than the primary model 302 and may be configured to modify the output of the primary model 302. As with the primary model 302, the secondary model 304 may be implemented using a machine learning model, which may be trained based on one or more characteristics of the input signal. For example, the secondary model 304, like the primary model 302 may be trained based on the amount of charge trapping state over time for a GaN power amplifier. As another example, the primary model 302 and the secondary model 304 may be trained based on a power level or signal strength of the input signal. In yet other examples, the primary model 302 and the secondary model 304 may be trained based on a bandwidth of the input signal. In some cases, one or more of the primary model 302 and the secondary model 304 may be trained to track the changes in the state of the power amplifier 202 or the characteristics of the input.

The digital predistortion system 204 may further include a weighting processor 306. The weighting processor 306 may generate a weighting value that is used to weight the output of the secondary model 304. This weighted output of the secondary model 304 may be used to affect the amount of fine tuning performed by the secondary model 304. This weighting value may be between 0 and 1. For example, if the output of the weighting processor 306 is 0, then the secondary model 304 does not modify the output of the primary model 302 and the predistortion value is based solely on the primary model 302. On the other hand, if the weighting value is 1, then the output of the secondary model 304 may maximally modify or finetune the predistortion value generated by the primary model 302. In certain embodiments, because the secondary model 304 is configured to refine the output of the primary model 302, even when the weighting value is set to 1, the output of the primary model 302 may have a greater impact on the predistortion value than the output of the secondary model 304. In other embodiments, the secondary model 304 may be configured to provide a greater impact on the predistortion value than the primary model 302.

In some cases, the weighting processor 306 may implement a model to determine a weight to apply to the secondary model 304. The model implemented by the weighting processor 306 may be trained to track the changes in the state of the power amplifier 202 or the characteristics of the input.

The weighting processor 306 may generate the weighting value based on a weighting parameter, S. This weighting parameter may be based on one or more characteristics of the input signal. For example, the weighting parameter may be one or more of a time value, a power output value of the power amplifier, or a bandwidth of a transmission signal. The weighting value may be determined using any type of weighting algorithm that may determining the weighting value based on the weighting parameter. For example, the weighting algorithm may be a sigmoid function.

The digital predistortion system 204 may further include a multiplier 308. The multiplier 308 may be a configurable multiplier that modifies the output of the secondary model 304 by the weighting value determined by the weighting processor 306.

The digital predistortion system 204 may combine the weighted output of the secondary model 304 with the output of the primary model 302 using a combiner 310 to obtain the input signal modified with the digital predistortion signal, Z. This modified signal Z may be supplied as an input to the power amplifier 202. The combiner 310 may be configured to combine an initial predistortion signal that is output by the primary model 302 with a weighted output of the secondary model 304 to generate a digital predistortion signal for the power amplifier 202.

As previously described, the output of the secondary model 304 may be weighted based on time, which may correspond to the amount of charge trapped, or based on some other factor. These other factors may include any characteristic of the input signal, X, such as power or bandwidth. In some cases, the weighting processor 306 may account for multiple signal characteristics in determining a weighing value for the output of the secondary model 304. In other embodiments, the digital predistortion system 204 may include multiple auxiliary models that may each be associated with refining the output of the primary model 302 based on different characteristics of the input signal.

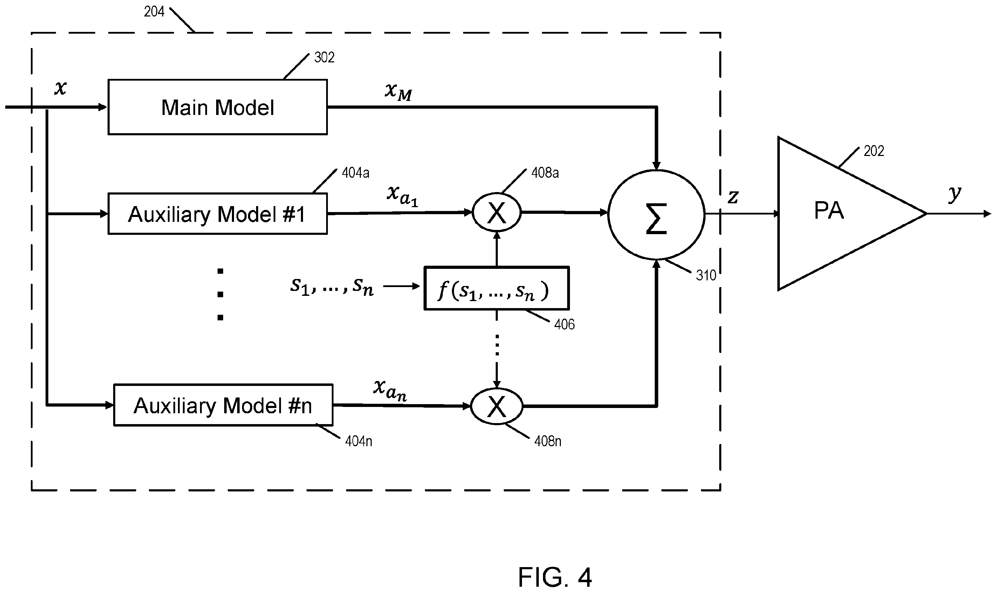

Figure 4 illustrates an example implementation of a digital predistortion system with multiple auxiliary models (404a-404n) in accordance with certain embodiments. The multiple auxiliary models may individually or collectively be referred to as auxiliary models 404. Each of the auxiliary models 404 may be associated with a different model that is configured to refine the output of the primary model 302 based on a different factor or characteristic of the signal, X.

Each of the auxiliary models 404 may be weighted by a weighting processor 406. The weighting processor 406 may evaluate a plurality of different signal characteristics to determine the weights to apply to the auxiliary models 404. The weighted outputs of each of the auxiliary models 404 may be combined with the output of the primary model 302 by the combiner 310 to generate the signal Z that is a predistorted version of the input signal X.

### Terminology

Conditional language used herein, such as, among others, "can," "could," "might," "may," "e.g.," and the like, unless specifically stated otherwise, or otherwise understood within the context as used, may be generally intended to convey that certain embodiments include, while other embodiments do not include, certain features, elements and/or states. Thus, such conditional language may be not generally intended to imply that features, elements and/or states may be in any way required for one or more embodiments or that one or more embodiments necessarily include these features, elements and/or states.

Conjunctive language such as the phrase "at least one of X, Y, and Z," unless specifically stated otherwise, may be otherwise understood with the context as used in general to convey that an item, term, etc. may be either X, Y, or Z. Thus, such conjunctive language may be not generally intended to imply that certain embodiments require the presence of at least one of X, at least one of Y, and at least one of Z.

While the above detailed description may have shown, described, and pointed out novel features as applied to various embodiments, it may be understood that various omissions, substitutions, and/or changes in the form and details of any particular embodiment may be made without departing from the spirit of the disclosure. As may be recognized, certain embodiments may be embodied within a form that does not provide all of the features and benefits set forth herein, as some features may be used or practiced separately from others.

All of the processes described herein may be embodied in, and fully automated via, software code modules executed by a computing system that includes one or more computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the embodiment, certain acts, events, or functions of any of the algorithms described herein can be performed in a different sequence, can be added, merged, or left out altogether (for example, not all described acts or events are necessary for the practice of the algorithms). Moreover, in certain embodiments, acts or events can be performed concurrently, for example, through multi-threaded processing, interrupt processing, or multiple processors or processor cores or on other parallel architectures, rather than sequentially. In addition, different tasks or processes can be performed by different machines and/or computing systems that can function together.

The various illustrative logical blocks and modules described in connection with the embodiments disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combinations of the same, or the like. A processor can include electrical circuitry configured to process computer-executable instructions. In another embodiment, a processor includes an FPGA or other programmable device that performs logic operations without processing computer-executable instructions. A processor can also be implemented as a combination of computing devices, for example, a combination of a DSP and a microprocessor, a plurality of microprocessors, one or more microprocessors in conjunction with a DSP core, or any other such configuration. Although described herein primarily with respect to digital technology, a processor may also include primarily analog components. A computing environment can include any type of computer system, including, but not limited to, a computer system based on a microprocessor, a mainframe computer, a digital signal processor, a portable computing device, a device controller, or a computational engine within an appliance, to name a few.

Additionally, features described in connection with one embodiment can be incorporated into another of the disclosed embodiments, even if not expressly discussed herein, and embodiments may have the combination of features still fall within the scope of the disclosure. For example, features described above in connection with one embodiment can be used with a different embodiment described herein and the combination still fall within the scope of the disclosure.

It should be understood that various features and aspects of the disclosed embodiments can be combined with, or substituted for, one another in order to form varying modes of the embodiments of the disclosure. Thus, it may be intended that the scope of the disclosure herein should not be limited by the particular embodiments described above. Accordingly, unless otherwise stated, or unless clearly incompatible, each embodiment of this disclosure may comprise, additional to its essential features described herein, one or more features as described herein from each other embodiment disclosed herein.

Features, materials, characteristics, or groups described in conjunction with a particular aspect, embodiment, or example may be to be understood to be applicable to any other aspect, embodiment or example described in this section or elsewhere in this specification unless incompatible therewith. All of the features disclosed in this specification (including any accompanying claims, abstract and drawings), and/or all of the steps of any method or process so disclosed, may be combined in any combination, except combinations where at least some of such features and/or steps may be mutually exclusive. The protection may be not restricted to the details of any foregoing embodiments. The protection extends to any novel one, or any novel combination, of the features disclosed in this specification (including any accompanying claims, abstract and drawings), or to any novel one, or any novel combination, of the steps of any method or process so disclosed.

Furthermore, the features and attributes of the specific embodiments disclosed above may be combined in different ways to form additional embodiments, all of which fall within the scope of the present disclosure. Also, the separation of various system components in the implementations described above should not be understood as requiring such separation in all implementations, and it should be understood that the described components and systems can generally be integrated together in a single product or packaged into multiple products.

Moreover, while operations may be depicted in the drawings or described in the specification in a particular order, such operations need not be performed in the particular order shown or in sequential order, or that all operations be performed, to achieve desirable results. Other operations that may be not depicted or described can be incorporated in the example methods and processes. For example, one or more additional operations can be performed before, after, simultaneously, or between any of the described operations. Further, the operations may be rearranged or reordered in other implementations, including being performed at least partially in parallel. Those skilled in the art will appreciate that in some embodiments, the actual steps taken in the processes illustrated and/or disclosed may differ from those shown in the figures. Depending on the embodiment, certain of the steps described above may be removed, others may be added.

For purposes of this disclosure, certain aspects, advantages, and novel features may be described herein. Not necessarily all such advantages may be achieved in accordance with any particular embodiment. Thus, for example, those skilled in the art will recognize that the disclosure may be embodied or carried out in a manner that achieves one advantage or a group of advantages as taught herein without necessarily achieving other advantages as may be taught or suggested herein.

Language of degree used herein, such as the terms "approximately," "about," "generally," and "substantially" as used herein represent a value, amount, or characteristic close to the stated value, amount, or characteristic that still performs a desired function or achieves a desired result. For example, the terms "approximately", "about", "generally," and "substantially" may refer to an amount that may be within less than 10% of, within less than 5% of, within less than 1% of, within less than 0.1% of, and within less than 0.01% of the stated amount. As another example, in certain embodiments, the terms "generally parallel" and "substantially parallel" refer to a value, amount, or characteristic that departs from exactly parallel by less than or equal to 15 degrees, 10 degrees, 5 degrees, 3 degrees, 1 degree, 0.1 degree, or otherwise.

The scope of the present disclosure may be not intended to be limited by the specific disclosures of preferred embodiments in this section or elsewhere in this specification, and may be defined by claims as presented in this section or elsewhere in this specification or as presented in the future. The language of the claims may be to be interpreted broadly based on the language employed in the claims and not limited to the examples described in the present specification or during the prosecution of the application, which examples may be to be construed as non-exclusive.

Unless the context clearly may require otherwise, throughout the description and the claims, the words "comprise", "comprising", and the like, may be construed in an inclusive sense as opposed to an exclusive or exhaustive sense, that may be to say, in the sense of "including, but not limited to".

### Numbered aspects

By way of non-limiting example, some aspects of the disclosure are set out in the following numbered clauses.
Numbered Clause 1. A digital predistortion system configured to distort a power amplifier input signal prior to being input to a power amplifier, the digital predistortion system comprising:
   a compensator comprising:
   a first model implemented using a first processing circuit block configured to implement a transformation function to generate an initial predistortion signal based on an input signal corresponding to an output of a power amplifier;
   a second model implemented using a second processing circuit block configured to implement a modification function to modify the initial predistortion signal generated by the first model;
   a weighting processor configured to generate a weighting value based at least in part on a weighting parameter;
   a configurable multiplier configured to weight an output of the second model based at least in part on the weighting value generated by the weighting processor to obtain a weighted output; and
   a combiner configured to combine the initial predistortion signal that is output by the first model with the weighted output to generate a digital predistortion signal for the power amplifier in communication with the digital predistortion system.
Numbered Clause 2. The digital predistortion system of Numbered Clause 1, wherein the first model comprises a primary model configured to generate the initial predistortion signal and the second model comprises a secondary model configured to adjust the primary model.
Numbered Clause 3. The digital predistortion system of Numbered Clause 1 or 2, wherein the weighting parameter comprises one or more of a time value, a power output value of the power amplifier, or a bandwidth of a transmission signal.
Numbered Clause 4. The digital predistortion system of any preceding Numbered Clause, wherein the weighting value is set to zero when the weighting parameter is at a maximum value.
Numbered Clause 5. The digital predistortion system of any preceding Numbered Clause, wherein the weighting value is set to one when the weighting parameter satisfies a steady state condition.
Numbered Clause 6. The digital predistortion system of any preceding Numbered Clause, wherein the weighting parameter corresponds to a characteristic of the input signal. Numbered Clause 7. The digital predistortion system of any preceding Numbered Clause, wherein the first model comprises a machine learning model that is trained with a dynamic input signal.
Numbered Clause 8. The digital predistortion system of any preceding Numbered Clause, wherein the weighting processor generates the weighting value using a real-to-complex operator selected from at least one of the following: a piecewise function, a sigmoid function, a tanh, function, or a rectified linear unit function.
Numbered Clause 9. The digital predistortion system of any preceding Numbered Clause, wherein the weighting processor generates the weighting value using a weight generation model trained based at least in part on one or more of a time constant of the power amplifier or a process used to manufacture the power amplifier.
Numbered Clause 10. The digital predistortion system of any preceding Numbered Clause, further comprising a third model implemented using a third processing circuit block configured to implement a second modification function to modify the initial predistortion signal generated by the first model.
Numbered Clause 11. The digital predistortion system of Numbered Clause 10, wherein the second modification function modifies the initial predistortion signal generated by the first model based on a second weighting parameter that differs from the weighting parameter.
Numbered Clause 12. A transceiver comprising:
   a power amplifier;
   a digital predistortion system; and
   a controller configured to generate a control signal to control operation of the digital predistortion system,
   wherein the digital predistortion system is connected in series with the power amplifier, and wherein the digital predistortion system comprises a compensator that comprises:
      a first model implemented using a first processing circuit block configured to implement a transformation function to generate an initial predistortion signal based on an input signal corresponding to an output of the power amplifier;
      a second model implemented using a second processing circuit block configured to implement a modification function to modify the initial predistortion signal generated by the first model;
      a weighting processor configured to generate a weighting value based at least in part on the control signal;
      a configurable multiplier configured to weight an output of the second model based at least in part on the weighting value generated by the weighting processor to obtain a weighted output; and
      a combiner configured to combine the initial predistortion signal that is output by the first model with the weighted output to generate a digital predistortion signal for the power amplifier in communication with the digital predistortion system.
Numbered Clause 13. The transceiver of Numbered Clause 12, wherein the control signal is generated based at least in part on a passage of time over a time period associated with a transmission signal.
Numbered Clause 14. The transceiver of Numbered Clause 12 or 13, wherein the control signal is generated based at least in part on a power output of the power amplifier.
Numbered Clause 15. The transceiver of any of Numbered Clauses 12 to 14, wherein the weighting processor generates the weighting value using a weight generation model trained based at least in part on one or more of a time constant of the power amplifier or a process used to manufacture the power amplifier.
Numbered Clause 16. The transceiver of any of Numbered Clauses 12 to 15, wherein the digital predistortion system further comprises a third model implemented using a third processing circuit block configured to implement a second modification function to modify the initial predistortion signal generated by the first model.
Numbered Clause 17. The transceiver of Numbered Clause 16, wherein the control signal is associated with a weighting parameter corresponding to the input signal, and wherein the second modification function modifies the initial predistortion signal generated by the first model based on a second control signal that is associated with a different weighting parameter than the control signal.
Numbered Clause 18. A wireless device comprising:
   an antenna configured to emit a signal received from a power amplifier; and
   a transceiver comprising the power amplifier and a digital predistortion system connected in series with the power amplifier, the digital predistortion system comprising:
      a primary model implemented using a first processing circuit block configured to implement a transformation function to generate an initial predistortion signal based on an input signal corresponding to an output of the power amplifier;
      an auxiliary model implemented using a second processing circuit block configured to implement a modification function to modify the initial predistortion signal generated by the primary model;
      a weighting processor configured to generate a weighting value based at least in part on a control signal;
      a configurable multiplier configured to weight an output of the auxiliary model based at least in part on the weighting value generated by the weighting processor to obtain a weighted output; and
      a combiner configured to combine the initial predistortion signal that is output by the primary model with the weighted output to generate a digital predistortion signal for the power amplifier in communication with the digital predistortion system.
Numbered Clause 19. The wireless device of Numbered Clause 18, wherein the wireless device is a base station.
Numbered Clause 20. The wireless device of Numbered Clause 18 or 19, wherein the control signal corresponds to a characteristic of the input signal.

## Claims

1. A digital predistortion system configured to distort a power amplifier input signal prior to being input to a power amplifier, the digital predistortion system comprising:
a compensator comprising:
a first model implemented using a first processing circuit block configured to implement a transformation function to generate an initial predistortion signal based on an input signal corresponding to an output of a power amplifier;
a second model implemented using a second processing circuit block configured to implement a modification function to modify the initial predistortion signal generated by the first model;
a weighting processor configured to generate a weighting value based at least in part on a weighting parameter;
a configurable multiplier configured to weight an output of the second model based at least in part on the weighting value generated by the weighting processor to obtain a weighted output; and
a combiner configured to combine the initial predistortion signal that is output by the first model with the weighted output to generate a digital predistortion signal for the power amplifier in communication with the digital predistortion system.

2. The digital predistortion system of claim 1, wherein the first model comprises a primary model configured to generate the initial predistortion signal and the second model comprises a secondary model configured to adjust the primary model.

3. The digital predistortion system of claim 1 or 2, wherein the weighting parameter comprises one or more of a time value, a power output value of the power amplifier, or a bandwidth of a transmission signal.

4. The digital predistortion system of any preceding claim, wherein the weighting value is set to zero when the weighting parameter is at a maximum value and/or wherein the weighting value is set to one when the weighting parameter satisfies a steady state condition.

5. The digital predistortion system of any preceding claim, wherein the weighting parameter corresponds to a characteristic of the input signal.

6. The digital predistortion system of any preceding claim, wherein the first model comprises a machine learning model that is trained with a dynamic input signal.

7. The digital predistortion system of any preceding claim, wherein the weighting processor generates the weighting value using a real-to-complex operator selected from at least one of the following: a piecewise function, a sigmoid function, a tanh, function, or a rectified linear unit function and/or wherein the weighting processor generates the weighting value using a weight generation model trained based at least in part on one or more of a time constant of the power amplifier or a process used to manufacture the power amplifier.

8. The digital predistortion system of any preceding claim, further comprising a third model implemented using a third processing circuit block configured to implement a second modification function to modify the initial predistortion signal generated by the first model, preferably wherein the second modification function modifies the initial predistortion signal generated by the first model based on a second weighting parameter that differs from the weighting parameter.

9. A transceiver comprising:
a power amplifier;
a digital predistortion system; and
a controller configured to generate a control signal to control operation of the digital predistortion system,
wherein the digital predistortion system is connected in series with the power amplifier, and wherein the digital predistortion system comprises a compensator that comprises:
a first model implemented using a first processing circuit block configured to implement a transformation function to generate an initial predistortion signal based on an input signal corresponding to an output of the power amplifier;
a second model implemented using a second processing circuit block configured to implement a modification function to modify the initial predistortion signal generated by the first model;
a weighting processor configured to generate a weighting value based at least in part on the control signal;
a configurable multiplier configured to weight an output of the second model based at least in part on the weighting value generated by the weighting processor to obtain a weighted output; and
a combiner configured to combine the initial predistortion signal that is output by the first model with the weighted output to generate a digital predistortion signal for the power amplifier in communication with the digital predistortion system.

10. The transceiver of claim 9, wherein the control signal is generated based at least in part on a passage of time over a time period associated with a transmission signal.

11. The transceiver of claim 9 or 10, wherein the control signal is generated based at least in part on a power output of the power amplifier.

12. The transceiver of any of claims 9 to 11, wherein the weighting processor generates the weighting value using a weight generation model trained based at least in part on one or more of a time constant of the power amplifier or a process used to manufacture the power amplifier.

13. The transceiver of claim 12, wherein the digital predistortion system further comprises a third model implemented using a third processing circuit block configured to implement a second modification function to modify the initial predistortion signal generated by the first model, preferably wherein the control signal is associated with a weighting parameter corresponding to the input signal, and wherein the second modification function modifies the initial predistortion signal generated by the first model based on a second control signal that is associated with a different weighting parameter than the control signal.

14. A wireless device comprising:
an antenna configured to emit a signal received from a power amplifier; and
a transceiver comprising the power amplifier and a digital predistortion system connected in series with the power amplifier, the digital predistortion system comprising:
a primary model implemented using a first processing circuit block configured to implement a transformation function to generate an initial predistortion signal based on an input signal corresponding to an output of the power amplifier;
an auxiliary model implemented using a second processing circuit block configured to implement a modification function to modify the initial predistortion signal generated by the primary model;
a weighting processor configured to generate a weighting value based at least in part on a control signal;
a configurable multiplier configured to weight an output of the auxiliary model based at least in part on the weighting value generated by the weighting processor to obtain a weighted output; and
a combiner configured to combine the initial predistortion signal that is output by the primary model with the weighted output to generate a digital predistortion signal for the power amplifier in communication with the digital predistortion system.

15. The wireless device of claim 14, wherein the wireless device is a base station and/or wherein the control signal corresponds to a characteristic of the input signal.
